(19) **Europäisches Patentamt**
**European Patent Office**
**Office européen des brevets**

(11) **EP 3 726 680 A1**

(12) **EUROPEAN PATENT APPLICATION**

(43) Date of publication:
**21.10.2020 Bulletin 2020/43**

(51) Int Cl.:
**H02H 3/33** *(2006.01)* **G01R 15/18** *(2006.01)*
**H02H 3/347** *(2006.01)*

(21) Application number: **19169253.2**

(22) Date of filing: **15.04.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ABB Schweiz AG**
**5400 Baden (CH)**

(72) Inventors:
• **Macerini, Sauro**
**I-52021 Bucine (AR) (IT)**
• **Pancani, Emanuele**
**I-50055 Lastra a Signa (FI) (IT)**
• **Carpentieri, Vincenzo**
**I-52028 Terranuova Bracciolini (AR) (IT)**

(74) Representative: **De Bortoli, Eros et al**
**Zanoli & Giavarini S.p.A.**
**Via Melchiorre Gioia, 64**
**20125 Milano (IT)**

(54) **A RESIDUAL CURRENT DEVICE FOR LOW VOLTAGE APPLICATIONS**

(57) A residual current device (for low-voltage applications characterised in that it comprises:
- a current sensor operatively coupleable with at least a line conductor of an electric line, said current sensor including a saturable magnetic core and a secondary winding wound around said magnetic core;
- a first detection module adapted to provide a first detection signal indicative of a winding current circulating along the secondary winding of said current sensor;
- a comparator module adapted to process said first detection signal and provide a first logic signal and a second logic signal, each of said first and second logic signals taking a high logic level or a low logic level depending on the behavior of the winding current circulating along the secondary winding of said current sensor;
- a logic module adapted to process said first and second logic signals (S, R) and provide a third logic signal and a fourth logic signal 1, each of said first and second logic signals taking a high logic level or a low logic level depending on the behavior of said first and second logic signals;
- a driving module adapted to process said third and fourth logic signals and provide a bipolar driving voltage to the secondary winding of said current sensor, said driving voltage being configured to drive the magnetic core of said current sensor in a saturation condition and to change polarity when said magnetic core reaches said saturation condition, said driving voltage taking a positive polarity or a negative polarity depending on the behavior of said third and fourth logic signals;
- a second detection module adapted to process said third logic signal or said fourth logic signals and provide a second detection signal (M) indicative of a duty-cycle of said third logic signal or said fourth logic signal;
- a determination module adapted to process said second detection signal and provide a determination value indicative of leakage currents in said electric line.

Preferably, the residual current device, according to the invention, comprises a test module adapted to provide a test logic signal TS to carry out a self-test procedure of the operation of the residual current device.

EP 3 726 680 A1

FIG. 1

**Description**

The present invention relates to a residual current device for low voltage applications.

For the purposes of the present application, the term "low voltage" (LV) relates to operating voltages lower than 1 kV AC and 2 kV DC.

Residual current devices (RCDs) are widely used in low voltage applications for early detection of leakage currents towards earth (ground faults), which is essential to guarantee safety of electric lines.

In photovoltaic inverters, RCDs are normally required to be sensitive to possible DC and AC leakage currents due to the DC nature of electric power provided by photovoltaic panels or strings.

As is known, most of currently available RCDs are based on so-called "fluxgate technology". Examples of these devices are described in US2011/0006779A1 and EP2632010A1.

In general, these devices have proven to be quite accurate, reliable and efficient in detecting DC or AC leakage currents.

However, for the time being, currently available solutions of this type are quite complex and expensive to manufacture at industrial level.

In the state of the art, it is still quite felt the need for innovative RCDs capable of providing reliable and accurate detection performances and relatively easy and inexpensive to produce at industrial level.

In order to respond to this need, the present invention provides a residual current device according to the following claim 1 and the related dependent claims.

According to a further aspect, the present invention relates to an inverter for photovoltaic plants including said residual current device.

Characteristics and advantages of the invention will become apparent from the detailed description of exemplary embodiments of the residual current device, according to the invention, which is illustrated only by way of non-limitative examples in the accompanying drawings, wherein:

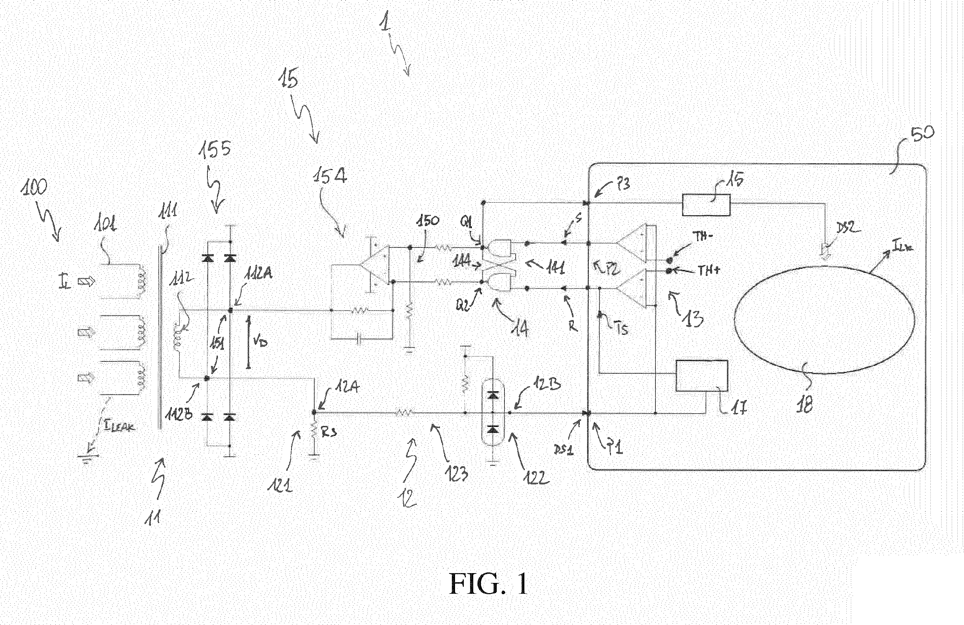

Figure 1 is a block diagram of an embodiment of the residual current device, according to the invention;
Figure 2 is a block diagram of variant embodiment of the residual current device, according to the invention;
Figure 2A schematically shows a further variant embodiment of the residual current device, according to the invention;
Figure 3 is a schematic diagram shown the behavior of some electric quantities in the residual current device, according to the invention.

With reference to the cited figures, the present invention relates to a residual current device (RCD) 1 that, in operation, is operatively associated to a low-voltage electric line 100.

In principle, the electric line 100 may be the electric line of any LV installation.

The electric line 100 comprises one or more conductors 101, for example one or more line conductors and, possibly, also a neutral conductor.

The electric line 100 is intended to be electrically connected with an electric power source and an electric load (not shown), which may be of any type.

In operation, suitable electric currents $I_L$ having DC and/or AC components will flow along the conductors of the electric line 100.

If undesired leakage currents $I_{LEAK}$ having DC and/or AC components affect the electric line 100, unbalancing currents will flow along the secondary winding.

Anyway, the overall winding current $I_W$ circulating along the secondary winding 112 of the current sensor 11 will also depend by the voltage $V_D$ applied to said secondary winding.

In the following, the RCD 1 will be described with particular reference to an electric line of a photovoltaic inverter for the sake of simplicity only, without intending to limit the scope of the invention.

As the skilled person will certainly understand, the RCD 1 may be used in different LV applications, according to the needs.

The RCD 1 comprises an innovative arrangement for measuring possible DC or AC leakage currents affecting the electric line 100.

Such an innovative arrangement comprises a number of operating modules 12, 13, 14, 15, 16, 17, 18 that may be industrially implemented in an analog and/or digital manner.

If they are implemented in analog manner, said modules will comprise electronic circuits suitably arranged to perform their functionalities. Said electronic circuits may form separated circuit units or may be at least partially integrated in one or more circuit units.

If they are implemented in a digital manner, such operating modules will comprise suitable data processing resources on board one or more digital processing device (preferably on board a single digital processing device such as a DSP or microcontroller) and capable of executing software instructions stored in a medium to perform their functionalities.

The present invention will be now described in details with reference to a preferred embodiment (shown in the cited figures), in which the operating modules 12, 14, 15 are implemented by suitable electronic circuits and the operating modules 13, 16, 17, 18 are implemented by digital processing resources on board a digital processing device 50, for example a DSP or a microcontroller.

Conveniently, the digital processing device comprises digital processing resource to convert analog signals received at suitable input ports in corresponding digital signals and convert digital signals made available at suitable output ports in corresponding analog signals.

The digitalization of the operating modules 13, 16, 17, 18 provides relevant advantages as it allows simplifying the structure and operation of the RCD 1 and it facilitates the integration of the RCD 1 with the installation to which said RCD is dedicated (e.g. the integration with a DSP on onboard a photovoltaic inverter), thereby reducing the need for dedicated hardware and wirings.

According to the invention, the RCD 1 comprises a current sensor 11.

In operation, the current sensor 11 is operatively coupled with one or more line conductors 101 of the electric line 100 and it comprises a saturable magnetic core 111 and a secondary winding 112 wound around said magnetic core.

Conveniently, the line conductors 101 are operatively coupled with the current sensor 11 in such a way to form corresponding primary windings suitably enchained with the magnetic core 111.

Conveniently, the secondary winding 112 comprises winding terminals 112A, 112B for electrical connection with the remaining components of the RCD 1.

In general, the current sensor 11 may be of known type and it will not be further described in more details for the sake of brevity.

According to the invention, the RCD 1 comprises a first detection module 12 adapted to provide a first detection signal DS1, preferably a voltage detection signal.

The first detection signal DS1 is indicative of the winding current $I_W$ circulating along the secondary winding 112 of the current sensor 11.

Preferably, the first detection module 12 is formed by an analog current detection circuit electrically connected between the secondary winding 112 of the current sensor 11 and the digital processing device 50.

Conveniently, the detection circuit 12 has an input terminal 12A and an output terminal 12B, which are electrically connected with a winding terminal 112B of the secondary winding 112 and with a corresponding first port P1 of the digital processing device 50, respectively. Preferably, the current detection circuit 12 comprises a detection stage 121, which is conveniently formed by a suitable shunt resistor RS electrically connected between the input terminal 12A and the ground.

Preferably, the current detection circuit 12 comprises a transmission line 123 providing the first detection signal DS1 to the first port P1 of the digital processing device 50.

Preferably, the current detection circuit 12 comprises a protection stage 122, which conveniently comprises one or more diodes arranged between an intermediate node of the transmission line 123 and suitable voltage reference terminals, according to circuit configurations of known type.

According to the invention, the RCD 1 comprises a comparator module 13 adapted to process the first detection signal DS1 and provide a first logic signal S and a second logic signal R, preferably voltage logic signals.

Preferably, each logic signal S, R has a pulsed waveform variable in amplitude between two different logic levels, namely a high logic level $S_H$, $R_H$ (e.g. 3.3V) or a low logic level $S_L$, $R_L$ (e.g. 0.3 V).

Each logic signal S, R may take a high logic level $S_H$, $R_H$ or a low logic level $S_L$, $R_L$ depending on the behavior (in amplitude) of the winding current $I_W$ (first detection signal DS1) flowing along the secondary winding 122 of the current sensor 11.

Preferably, the comparator module 13 is adapted to compare the first detection signal DS1 with a positive threshold level TH+ and a negative threshold level TH- for the winding current $I_W$.

Preferably, the comparator module 13 provides the first logic signal S with logic levels $S_H$, $S_L$ that are indicative of whether the winding current $I_W$ exceeds or does not exceed the negative threshold level TH-.

Preferably, the comparator module 13 provides the second logic signal R with logic levels $R_H$, $R_L$ that are indicative of whether the winding current $I_W$ exceeds or does not exceed the positive threshold level TH+.

According to the embodiment shown in the cited figure, the comparator module 13 provides:

- said first logic signal S with a high logic level $S_H$, if the winding current $I_W$ is higher than said negative threshold level TH-;
- said first logic signal S with a low logic level $S_L$, if said winding current $I_W$ is lower said negative threshold level TH-;
- said second logic signal R with a high logic level $R_H$, if said winding current $I_W$ is lower than said positive threshold level TH+;
- said second logic signal R with a low logic level $R_L$, if said winding current $I_W$ is higher than said positive threshold level TH-.

In practice, the comparator module 13 conveniently provides logic functionalities according to the following table:

| $I_W$ < TH- | first logic signal S | second logic signal R |
|---|---|---|
| no | high | high |
| yes | low | high |

| $I_W$ > TH+ | first logic signal S | second logic signal R |
|---|---|---|
| no | high | high |
| yes | high | low |

The above-described solution has the advantage of simplifying the operation of the RCD 1 as the comparator module 13 can reliably operate as a hysteretic oscillator for controlling the logic module 14 operatively associated in cascade.

Additionally, the adoption of filtering circuits to filter the detection signal DS1 may be avoided.

Preferably, the comparator module 13 is digitally implemented by suitable digital processing resources of the digital processing device 50. To this aim, such processing resources may execute suitable algorithms of known type.

Conveniently, the comparator module 13 makes the logic signals S, R available at corresponding second ports P2 of the digital processing device 50.

According to the invention, the RCD 1 comprises a logic module 14 operatively associated in cascade to the comparator module 13.

The logic module 14 is adapted to process the first and second logic signals S, R provided by the comparator module 13.

The logic module 14 is adapted to provide a third logic signal Q1 and a fourth logic signal 1 Q2, which are preferably voltage logic signals.

Preferably, the logic signals Q1, Q2 have complementary pulsed waveforms variable in amplitude between two different logic levels $Q_H$ and $Q_L$, namely a high logic level (e.g. 3.3V) or a low logic level (0.3 V).

Each logic signal Q1, Q2 takes a high logic level $Q_H$ or a low logic level $Q_L$ depending on the behavior of the first and second logic signals S, R, in particular depending on the logic levels taken by these latter signals.

Preferably, the logic module 14 is adapted to carry out latch functionalities, more particularly so-called "SR-latch" functionalities.

According to the embodiment shown in the cited figure, the logic module 14:

- provides the third logic signal Q1 with a high logic level $Q_H$, if the first logic signal S has a low logic level $S_L$ and the second logic signal R has a high logic level $R_H$, and with a low logic level $Q_L$, if said first logic signal S has a high logic level $S_H$ and said second logic signal R has a low logic level $R_H$;
- provides said fourth logic signal Q2 with a high logic level $Q_L$, if said first logic signal S has a high logic level $S_H$ and said second logic signal R has a low logic level $R_L$, and with a low logic level $Q_L$, if said first logic signal S has a low logic level $S_L$ and said second logic signal R has a high logic level $R_H$;
- maintains unchanged the logic level of the third and fourth logic signals Q1, Q2, if both the first and second logic signals S, R have a high logic level.

In practice, the logic module 14 preferably provides logic functionalities according to the following logic table:

| first logic signal S | second logic signal R | third logic signal Q1 | fourth logic signal Q2 |
|---|---|---|---|
| high | low | low | high |
| low | high | high | low |
| high | high | latched | latched |

The above-described solution has the advantage of simplifying the operation of the RCD 1 as the logic module 14 can provide logic signals Q1, Q2 that can suitably control a driving module 15, which is operatively associated in cascade to the logic module 14, in accordance with the amplitude and sign of the winding current $I_W$ circulating along the secondary winding 122 of the current sensor 1.

Preferably, the logic module 14 is formed by an analog latch circuit electrically connected between the digital processing device 50 and the input terminals of the driving module 15 operatively associated in cascade.

Preferably, the latch circuit 14 comprises input terminals 141 electrically connected with the second ports P2 of the digital processing device 50 to receive the first and second logic signals S, R from this latter and corresponding output terminals 144 at which the third and fourth logic signals Q1, Q2 are made available.

Preferably, the latch circuit 14 implements a suitable combination of logic ports (e.g. NAND ports as shown in the cited figures) to implement the logic functionalities described above. According to the invention, the RCD 1 comprises a driving module 15 adapted to process the third and fourth logic signals Q1, Q and provide a bipolar driving voltage $V_D$ to the secondary winding 112 of the current sensor 1.

The bipolar driving voltage $V_D$ is conveniently configured in such a way to force the magnetic core 111 of the current sensor 1 to reach a saturation condition, namely a positive saturation condition or a negative saturation condition.

For the sake of clarity, it is specified that the term "positive saturation condition" refers to a saturation condition of the magnetic core 111, in which the winding current $I_W$ has a conventionally positive sign, whereas the term "negative saturation condition" refers to a saturation condition of the magnetic core 111, in which the winding current $I_W$ has a conventionally negative sign.

The bipolar driving voltage $V_D$ is additionally configured in such a way to change its polarity when the magnetic core 111 reaches said saturation condition, namely a positive saturation condition or a negative saturation condition.

Preferably, the driving voltage $V_D$ has a pulsed waveform variable in amplitude between a positive voltage level (e.g. 5V) and a negative voltage level (e.g. -5V).

According to the invention, the driving voltage $V_D$ takes a positive polarity (i.e. said positive voltage level) or a negative polarity (i.e. said negative voltage level) depending on the behavior of the third and fourth logic signals Q1, Q2, in particular depending on the logic levels taken by these latter logic signals.

According to the embodiment shown in the cited figure, the driving module 15:

- provides the driving voltage $V_D$ with a positive voltage polarity, if the third logic signal Q1 has a high logic level $Q_H$ and the fourth logic signal Q2 has a low logic level $Q_L$;
- provides the driving voltage $V_D$ with a negative voltage polarity, if the third logic signal Q1 has a low logic level $Q_L$ and the fourth logic signal Q2 has a high logic level $Q_H$.

In practice, the driving module 15 preferably sets the polarity of the driving voltage $V_D$ according to the following setting table:

| third logic signal Q1 | fourth logic signal Q2 | $V_D$ - voltage polarity |
|---|---|---|
| high | low | positive |
| low | high | negative |

The above-described solution allows greatly improving the accuracy of the RCD 1 as it allows achieving a stable and effective control of the operating conditions of the magnetic core 111 depending on the behavior of the logic signals Q2, Q1, which in turn behave in accordance with the amplitude and sign of the winding current $I_W$ circulating along the secondary winding 122 of the current sensor 1.

Preferably, the driving module 15 is formed by an analog driving circuit electrically connected between the logic module 14 and the secondary winding 112 of the current sensor 12.

Preferably, the driving circuit 15 has input terminals 150 electrically connected with the output terminals 144 of the logic circuit 144 and output terminals 151 electrically connected with the winding terminals 112A, 112B of the secondary winding 112.

Preferably, the driving circuit 15 comprises a driving stage 154 receiving the logic signals Q1, Q2 at the input terminals 150. Such a driving stage may have configurations of known type, e.g. including an operational amplifier having a differential configuration.

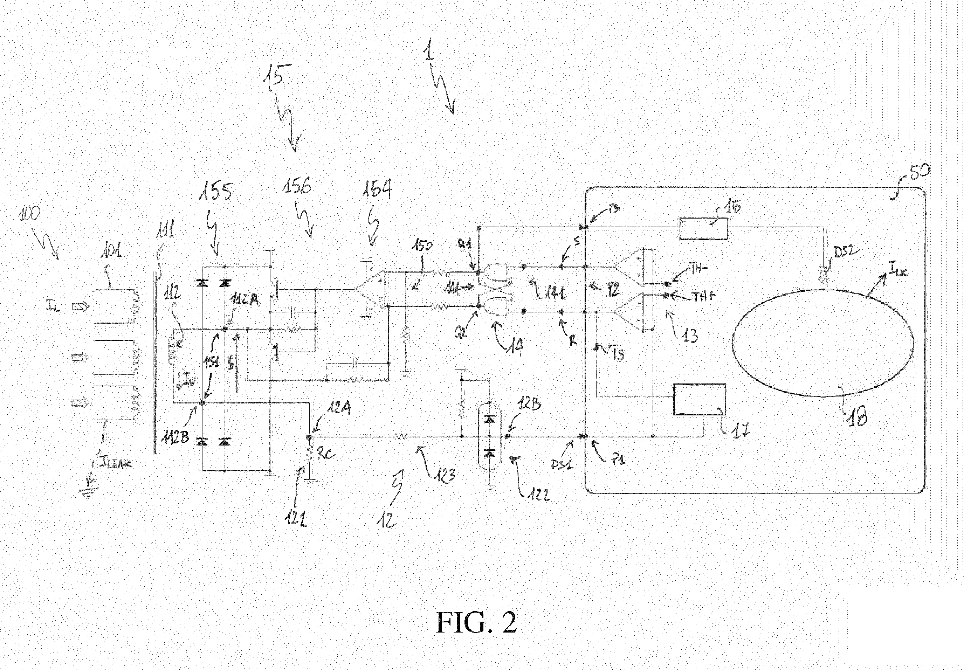

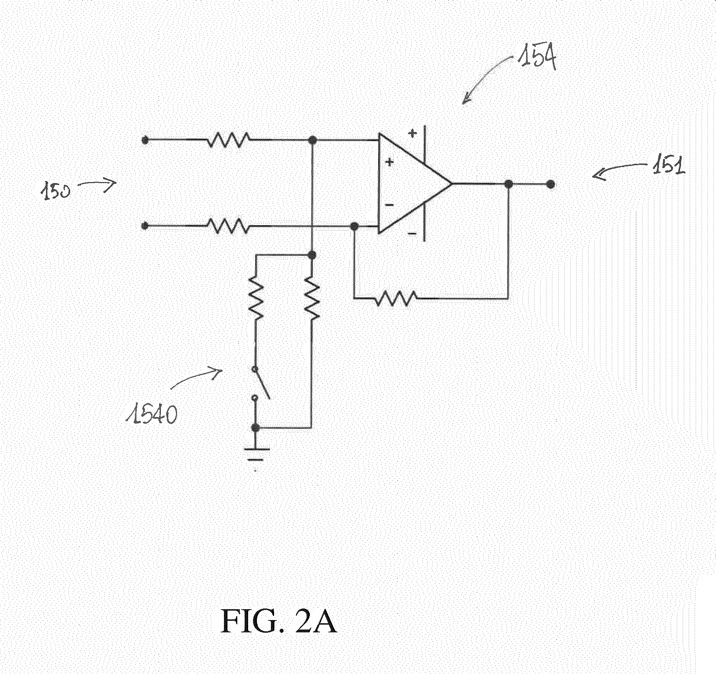

According to some embodiments of the invention (figure 2), the driving circuit 15 comprises an amplification stage 156 electrically connected between said driving stage and the output terminals 151. Such an amplification stage may have configurations of known type. e.g. including a pair of suitably coupled p-n-p and n-p-n BJT transistors.

According to a further variant shown in figure 2A, the driving circuit 15 includes a switching circuit 1540 that allows changing the balancing of the amplification provided the operational amplifier of the driving circuit 15.

In this way, it is possible to change the amplitude of the positive voltage level or negative voltage level of the driving voltage $V_D$, which may be useful for example during a self-test procedure of the RCD device 1.

In a practical implementation, the switching circuit 1540 may include an electronic switch (e.g. a FET transistor) or a mechanical switch electrically connected with an input terminal 150 of the driving circuit 15 through a suitable resistor.

Preferably, the driving circuit 15 comprises a protection stage 155 at the output terminals 151. Such a protection stage may conveniently comprise one or more diodes arranged between each output terminal 151 and suitable voltage reference terminals, according to circuit configurations of known type.

According to the invention, the RCD 1 comprises a second detection module 16 adapted to process the third logic signal Q1 or the fourth logic signals Q2 and provide a second detection signal DS2 indicative of the duty-cycle of the third logic signal Q1 or of the fourth logic signal Q2, measured in a time interval.

As the logic signals Q1 and Q2 are periodic signals with a variable period, such a predefined time interval may be a time period of the of the logic signal Q1 or Q2.

Conveniently, the duty cycle value D of the logic signal Q1 or Q2 is calculated basing on the following relation:

$$D = \frac{T_H}{T_H + T_L}$$

where $T_H$ is the period of time in which the logic signal Q1 or Q2 takes a high value and $T_L$ is the period of time in which the logic signal Q1 or Q2 takes a high value.

Preferably, the detection module 16 is digitally implemented by suitable digital processing resources of the digital processing device 50. To this aim, such processing resources may adopt suitable detection algorithms of known type.

Conveniently, the detection module 16 acquires the logic signals Q1 or Q2 at a third port P3 of the digital processing device 50, which is electrically connected with a corresponding suitable output terminal 144 of the logic circuit 14.

According to the invention, the RCD 1 comprises a determination module 18 adapted to process the second detection signal DS2 and provide a determination value $I_{LK}$ indicative of leakage currents in said electric line 100 basing on said second detection signal. Conveniently, the determination value $I_{LK}$ is calculated basing on the following relation:

$$I_{LK} = [(V_H - V_L) * D + V_L] * \frac{N}{R_S}$$

where $V_H$, $V_L$ are the positive and negative voltage levels taken by the driving voltage $V_D$, N is the number of turns of the secondary winding 112 around the magnetic core 111, D is the measured duty-cycle value and $R_S$ is the value of the shunt resistor $R_S$ employed in the measuring circuit 12. Conveniently, the above-mentioned values $V_H$, $V_L$, N, $R_S$ are predefined values stored in a memory of the digital processing device 50.

The above-mentioned relation finds its technical ground in the observation that the presence of leakage currents in the electric line 100 causes the rising of an offset component in the winding current $I_W$. This causes an increase or decrease of the time required by the magnetic core 111 to reach a saturation condition. In turn, this latter effect causes a corresponding variation of the duty-cycle of the logic signals Q1, Q2 that can be measured by the detection module 16 and subsequently processed by the determination module 18.

Preferably, the determination module 18 is digitally implemented by suitable digital processing resources of the digital processing device 50. To this aim, such processing resources may adopt a suitable calculation algorithm implementing the above-described relation.

According to an aspect of the invention, the RCD device 1 comprises a test module 17 adapted to provide a test logic signal TS to said logic module 14 in substitution of the first logic signal S or the second logic signal R for logic module 14.

The test module 17 is conveniently adapted to force the logic module 14 and the driving module 15 to operate according to known operating conditions in order to check whether anomalies are present in the RCD 1.

To this aim, the test logic signal TS is configured in such a way to force the logic module 14 to provide the third logic signal Q1 or the fourth logic signal Q2 in a predetermined way. In this way, the driving module 15 is forced to provide the driving voltage $V_D$ with the positive voltage level $V_H$ or the negative voltage level $V_L$.

In this way, predetermined operating conditions, in which leakage currents are present in said electric line 100, are basically simulated. In this situation, it is possible to check whether the RCD device 1 works properly by checking whether the determination value $I_{LK}$ provided by the determination module 18 corresponds to the above-mentioned known operating conditions.

Preferably, the test module 17 is digitally implemented by suitable digital processing resources of the digital processing device 50.

This solution provides the advantages of avoiding the arrangement of an additional secondary winding around the magnetic core 111, which allows further simplifying the internal structure of the RCD 1.

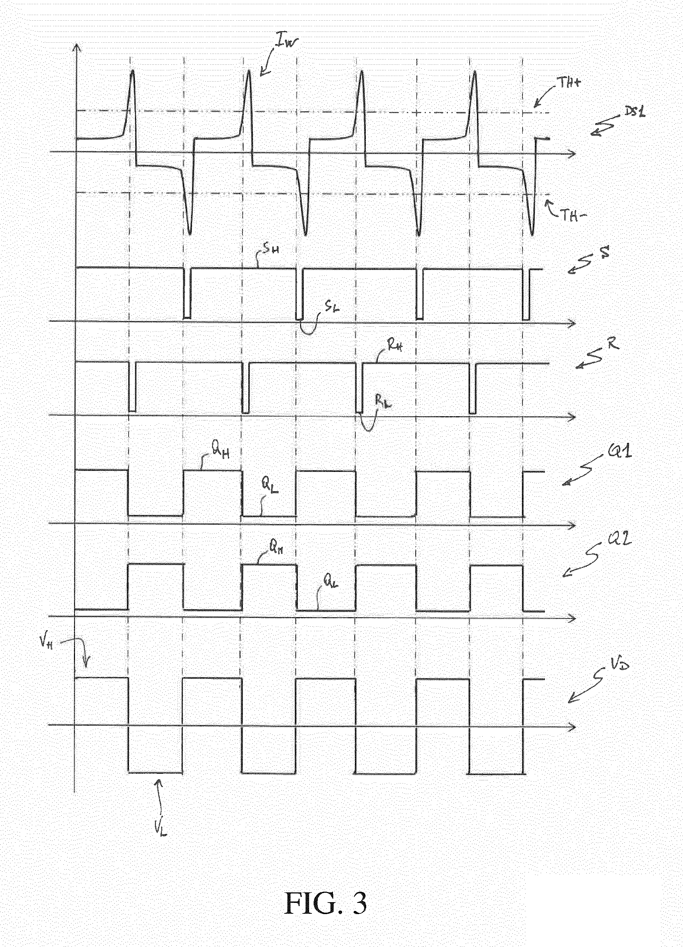

In figure 3, the behavior of the winding current IW, the logic signals S, R, Q1, Q2 and of the driving voltage $V_D$ is schematically represented.

The winding current $I_W$ is periodically subject to sudden inversions of sign in response to corresponding changes of polarity of the driving voltage $V_D$ applied to the secondary winding. At each inversion period, the winding current $I_W$ is subject to a sudden increase when the magnetic core 111 reaches a saturation condition.

The logic signals S, R take corresponding high levels $S_H$, $R_H$, when the winding current $I_W$ is lower than the positive threshold value TH+ and higher than the negative threshold value TH-, i.e. when the magnetic core 111 is not in a saturation condition.

The first logic signal S is subject to a transition from a corresponding high level $S_H$ to a corresponding low level $S_L$ when the winding current $I_W$ becomes higher than the positive threshold value TH+, i.e. the magnetic core 111 reaches a positive saturation condition.

The second logic signal R is subject to a transition from a corresponding high level $R_H$ to a corresponding low level $R_L$ when the winding current $I_W$ becomes higher than the positive threshold value TH+, i.e. the magnetic core 111 reaches a negative saturation region.

The logic signals Q1, Q2 are subject to level transitions in accordance with the latch functionalities provided by the logic module 14.

The driving voltage $V_D$ is subject to polarity transitions when both the logic signals Q1, Q2 are subject to level transitions, which occurs when the magnetic core 111 reaches a positive or a negative saturation condition.

The RCD 1, according to the invention, provides relevant advantages with respect to known solutions of the state of the art.

The RCD 1 provides outstanding performances in terms of accuracy and reliability in detecting leakage currents in the electric line 100.

The operating modules 12, 13, 14, 15 substantially implement a closed loop control of the operating conditions of the magnetic core 111 of the current sensor 11.

In fact, the magnetic flux flowing along the magnetic core 111 can be suitably reversed as soon as the magnetic core 111 reaches a saturation condition.

The behavior of the winding current $I_W$ flowing in the secondary winding 112 is therefore substantially immune to hysteresis effects of the magnetic flux and to possible temperature variations of the magnetic core.

The arrangement of the control module 14 providing latch functionalities allows further stabilizing the control of the operating conditions of the magnetic core 111 as the influence of high frequency disturbances is virtually eliminated.

As it is possible to appreciate from the above, determination values $I_{LK}$ indicative of possible leakage currents are calculated depending on the ratio of time quantities characterizing the third logic signal Q or the fourth logic signal Q2.

This allows reducing the data processing load to determine possible fault conditions as relatively simple detection and calculation algorithms may be suitably adopted.

The digital implementation of the operating modules 13, 16, 17, 18 allows decreasing the time response of the RCD 1. As a consequence, the RCD 1 is typically characterised by a remarkably larger bandwidth with respect to traditional detection devices of similar type. Additionally, the digital implementation of the operating modules 13, 16, 17, 18 allows an improved integration of the RCD 1 with the installation on which is intended to be arranged. As an example, the operating modules can be suitably implemented by a DSP on board a photovoltaic inverter, on which the RCD 1 is intended to be installed.

The RCD 1 has an extremely compact structure that has proven to be of easy industrial manufacture, at competitive costs with respect to available RCDs of the state of the art.

**Claims**

1. A residual current device (1) for low-voltage applications **characterised in that** it comprises:

   - a current sensor (11) operatively coupleable with at least a line conductor (101) of an electric line (100), said current sensor including a saturable magnetic core (111) and a secondary winding (112) wound around said magnetic core;
   - a first detection module (12) adapted to provide a first detection signal (DS1) indicative of a winding current ($I_W$) circulating along the secondary winding of said current sensor;
   - a comparator module (13) adapted to process said first detection signal (DS1) and provide a first logic signal

(S) and a second logic signal (R), each of said first and second logic signals taking a corresponding high logic level ($S_H$, $R_H$) or low logic level ($S_L$, $R_L$) depending on the behavior of the winding current ($I_W$) circulating along the secondary winding of said current sensor;
- a logic module (14) adapted to process said first and second logic signals (S, R) and provide a third logic signal (Q1) and a fourth logic signal (Q2), each of said first and second logic signals taking a corresponding high logic level ($Q_H$) or low logic level ($Q_L$) depending on the behavior of said first and second logic signals;
- a driving module (15) adapted to process said third and fourth logic signals (Q1, Q) and provide a bipolar driving voltage ($V_D$) to the secondary winding (112) of said current sensor, said driving voltage being configured to drive the magnetic core (111) of said current sensor (11) in a saturation condition and change polarity when said magnetic core reaches said saturation condition, said driving voltage taking a positive voltage level ($V_H$) or a negative voltage level ($V_L$) depending on the behavior of said third and fourth logic signals;
- a second detection module (16) adapted to process said third logic signal (Q1) or said fourth logic signal (Q2) and provide a second detection signal (DS2) indicative of a duty-cycle of said third logic signal or said fourth logic signal;
- a determination module (18) adapted to process said second detection signal (DS2) and calculate determination values ($I_{LK}$) indicative of leakage currents in said electric line (100) basing on said second detection signal.

2. Residual current device, according to claim 1, **characterised in that** said comparator module (13) is adapted to compare said first detection signal (DS1) with a positive threshold level (VT+) and a negative threshold level (TH-) for said winding current ($I_W$), said first logic signal (S) having logic levels indicative of whether said winding current ($I_W$) exceeds or does not exceed said negative threshold level (TH-), said second logic signal (R) having logic levels indicative of whether said winding current ($I_W$) exceeds or does not exceed said positive threshold level (TH+).

3. Residual current device, according to claim 2, **characterised in that** said comparator module (13) is adapted to provide:

- said first logic signal (S) with a high logic level ($S_H$), if said winding current ($I_W$) is higher than said negative threshold level (TH-);
- said first logic signal (S) with a low logic level ($S_L$), if said winding current ($I_W$) is lower said negative threshold level (TH-);
- said second logic signal (R) with a high logic level ($R_H$), if said winding current ($I_W$) is lower than said positive threshold level (TH+);
- said second logic signal (R) with a low logic level ($R_L$), if said winding current ($I_W$) is higher than said positive threshold level (TH+).

4. Residual current device, according to one or more of the previous claims, **characterised in that** said logic module (14) is adapted to carry out latch functionalities.

5. Residual current device, according to claim 4, **characterised in that** said logic module (14) is adapted to:

- provide said third logic signal (Q1) with a high logic level ($Q_H$), if said first logic signal (S) has a low logic level and said second logic signal (R) has a high logic level;
- provide said third logic signal (Q1) with a low logic level ($Q_L$), if said first logic signal (S) has a high logic level and said second logic signal (R) has a low logic level;
- provide said fourth logic signal (Q2) with a high logic level ($Q_H$), if said first logic signal (S) has a high logic level and said second logic signal (R) has a low logic level;
- provide said fourth logic signal (Q2) with a low logic level ($Q_L$), if said first logic signal (S) has a low logic level and said second logic signal (R) has a high logic level;
- maintain unchanged the logic levels ($Q_H$, $Q_L$) of said third and fourth logic signals (Q1, Q2) if both said first and second logic signals (S, R) have a high logic level.

6. Residual current device, according to one or more of the previous claims, **characterised in that** it comprises a test module (17) adapted to provide a test logic signal (TS) in substitution of said first logic signal (S) or said second logic signal (R) for said logic module (14).

7. Residual current device, according to claim 6, **characterized in that** said test logic signal (TS) is configured in such a way to force said logic module (14) to provide said third logic signal (Q1) or said fourth logic signal (Q2) in a predetermined way, thereby forcing said driving module (15) to provide a driving voltage ($V_D$) having a positive voltage level ($V_H$) or a negative voltage level ($V_L$) in a predetermined way.

8. Residual current device, according to one or more of the previous claims, **characterised in that** said comparator module (13), said second detection module (16 and said determination module (18) are digitally implemented on a digital processing device (50).

9. Residual current device, according to claim 6 or 7, **characterised in that** said test module (17) is digitally implemented on a digital processing device (50).

10. Residual current device, according to one or more of the previous claims, **characterised in that** said current detection module (12) comprises an analog current detection circuit electrically connected between the secondary winding (112) of said current sensor and a digital processing device (50) digitally implementing said comparator module (13).

11. Residual current device, according to one or more of the previous claims, **characterised in that** said logic module (14) comprises an analog logic circuit electrically connected with a digital processing device (50) digitally implementing said comparator module (13).

12. Residual current device, according to one or more of the previous claims, **characterised in that** said driving module (15) comprises an analog driving circuit electrically connected between said logic module (14) and the secondary winding (112) of said current sensor.

13. An inverter for photovoltaic plants **characterised in that** it comprises a RCD device (1) according to one or more of the previous claims.

FIG. 1

FIG. 2

FIG. 2A

FIG. 3

Europäisches
Patentamt

European
Patent Office

Office européen
des brevets

# EUROPEAN SEARCH REPORT

Application Number

EP 19 16 9253

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2012/091996 A1 (KOCH RALF [DE] ET AL) 19 April 2012 (2012-04-19)<br>* abstract *<br>* figures 1,6 *<br>* paragraph [0021] *<br>* paragraphs [0025], [0036] *<br>* paragraph [0043] *<br>----- | 1-13 | INV.<br>H02H3/33<br>G01R15/18<br>H02H3/347 |
| A | US 2009/108833 A1 (ZIEGLER SILVIO [AU]) 30 April 2009 (2009-04-30)<br>* abstract *<br>* figure 3 *<br>* paragraph [0022] *<br>* paragraph [0044] - paragraph [0046] *<br>* paragraph [0060] - paragraph [0061] *<br>----- | 1-13 | |
| A | US 7 528 594 B2 (ABB SPA [IT]) 5 May 2009 (2009-05-05)<br>* abstract *<br>* figure 1 *<br>* column 3, line 8 - line 27 *<br>----- | 1-13 | |
| Y | US 2014/320112 A1 (NODERA TOSHIO [JP] ET AL) 30 October 2014 (2014-10-30)<br>* abstract *<br>* figure 2 *<br>* paragraphs [0032], [0052] *<br>----- | 1-13 | TECHNICAL FIELDS SEARCHED (IPC)<br><br>H02H<br>G01R |

The present search report has been drawn up for all claims

| Place of search | Date of completion of the search | Examiner |
|---|---|---|
| Munich | 7 October 2019 | Operti, Antonio |

## ANNEX TO THE EUROPEAN SEARCH REPORT
## ON EUROPEAN PATENT APPLICATION NO.

EP 19 16 9253

This annex lists the patent family members relating to the patent documents cited in the above-mentioned European search report.
The members are as contained in the European Patent Office EDP file on
The European Patent Office is in no way liable for these particulars which are merely given for the purpose of information.

07-10-2019

| Patent document cited in search report | Publication date | Patent family member(s) | Publication date |
|---|---|---|---|
| US 2012091996 A1 | 19-04-2012 | AT 537458 T<br>DE 102008029475 A1<br>EP 2291665 A1<br>ES 2378638 T3<br>US 2012091996 A1<br>WO 2009153069 A1 | 15-12-2011<br>24-12-2009<br>09-03-2011<br>16-04-2012<br>19-04-2012<br>23-12-2009 |
| US 2009108833 A1 | 30-04-2009 | CN 102292717 A<br>EP 2220567 A1<br>HK 1162713 A1<br>JP 6045125 B2<br>JP 2011502261 A<br>US 2009108833 A1<br>WO 2009058524 A1 | 21-12-2011<br>25-08-2010<br>14-08-2015<br>14-12-2016<br>20-01-2011<br>30-04-2009<br>07-05-2009 |
| US 7528594 B2 | 05-05-2009 | AT 438103 T<br>CN 1712973 A<br>EP 1610133 A2<br>ES 2330345 T3<br>US 2005280409 A1 | 15-08-2009<br>28-12-2005<br>28-12-2005<br>09-12-2009<br>22-12-2005 |
| US 2014320112 A1 | 30-10-2014 | CN 104067134 A<br>EP 2821800 A1<br>JP 5948958 B2<br>JP 2013178205 A<br>KR 20140136917 A<br>US 2014320112 A1<br>WO 2013128803 A1 | 24-09-2014<br>07-01-2015<br>06-07-2016<br>09-09-2013<br>01-12-2014<br>30-10-2014<br>06-09-2013 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20110006779 A1

- EP 2632010 A1